# EUROPEAN PATENT APPLICATION

(11) **EP 4 425 962 A1**
(43) Date of publication of application: **04.09.2024**
(21) Application number: 24158761.7
(22) Date of filing: 21.02.2024
(51) Int. Cl.: H04R 3/06, H04R 19/04, H03F 3/45

(54) **MEMS COMPENSATION LOOP**

(30) Priority: 02.03.2023 US 202318177579
(71) Applicant: Infineon Technologies AG, 85579 Neubiberg (DE)
(72) Inventor: WIESBAUER, Andreas, 9210 Poertschach (AT); CEBALLOS, Jose Luis, 9500 Villach (AT); CICIOTTI, Fulvio, 9530 Bad Bleiberg (AT); MUEHLBACHER, Benno, 9524 St. Magdalen (AT); TZITZILAKI, Maria, 9500 Villach (AT); HASSAN, Mohammed Farag Nouraldin, 9500 Villach (AT)
(74) Representative: Hersina, Günter

(57) **Abstract**

In accordance with an embodiment, a circuit includes a differential amplifier having inputs configured to be coupled to an output of a differential microelectromechanical systems (MEMS) device; a common mode coupling circuit coupled to an output of the differential amplifier; and an amplifier having an input coupled to an output of the common mode coupling circuit and an output configured to be AC coupled to a bias input node of the differential MEMS device.

## Description

### TECHNICAL FIELD

The present invention relates generally to an electronic system and method, and, in particular embodiments, a microelectromechanical system (MEMS) compensation loop.

### BACKGROUND

MEMS based microphones transduce sound pressure into electronic signals by sensing a pressure difference using a movable membrane and sensing a change in capacitance between the movable membrane an a fixed backplate. Advantageously, MEMS devices may be manufactured using batch fabrication techniques similar to those used for integrated circuits. Therefore, functionality, reliability and sophistication may be integrated onto a small silicon chip at a relatively low cost.

A MEMS microphone typically includes a MEMS device and readout circuitry coupled to the MEMS device. In some cases, an analog-to-digital converter (ADC) may be coupled to the readout circuitry. The MEMS device converts environmental sound pressure into analog signals. To achieve high system linearity a differential MEMS device having a double-backplate (DBP) and a moveable membrane, or having a sealed dual membrane (SDM) may be used. The MEMS device is typically packaged in a package having a port so that the moveable membrane is in communication with the environmental sound pressure. The readout circuitry can include amplification circuits.

Differential MEMS can have a sensitivity mismatch between the two channels due to various factors such as mismatch in capacitance, bias voltage, and membrane stiffness. This asymmetry may also be signal level dependent and may be most severe at the higher voltages commonly used to increase overall MEMS sensitivity and performance. This mismatch in sensitivity may lead to signal distortion and poor total harmonic distortion (THD) at high sound levels.

### SUMMARY

In accordance with an embodiment, a circuit includes a differential amplifier having inputs configured to be coupled to an output of a differential microelectromechanical systems (MEMS) device; a common mode coupling circuit coupled to an output of the differential amplifier; and an amplifier having an input coupled to an output of the common mode coupling circuit and an output configured to be AC coupled to a bias input node of the differential MEMS device.

In accordance with another embodiment, a method of operating a differential microelectromechanical systems (MEMS) device includes amplifying a differential output of the differential MEMS device to produce a differential output signal; and reducing an asymmetry of the differential output signal by: generating a common mode AC voltage from the differential output signal, amplifying the common mode AC voltage, and feeding back the amplified common mode AC voltage to a bias input node of the differential MEMS device.

In accordance with a further embodiment, a microphone system includes: a differential microelectromechanical systems (MEMS) device; a differential amplifier coupled to an output of the differential MEMS device; an amplifier; a first impedance coupled between a first differential output of the differential amplifier and a first input node of the amplifier; a second impedance coupled between the first differential output of the differential amplifier and the first input node of the amplifier; a third capacitor coupled between an output of the amplifier and a bias input node of the differential MEMS device; and a bias generator DC coupled to the bias input node of the differential MEMS device.

### BRIEF DESCRIPTION OF THE DRAWINGS

For a more complete understanding of the present invention, and the advantages thereof, reference is now made to the following descriptions taken in conjunction with the accompanying drawings, in which:
Figure 1A is a schematic of a microphone system according to an embodiment, and Figures 1B and 2C are waveform diagrams that illustrate the operation of the microphone system of Figure 1A;
Figures 2A, 2B and 2C illustrate schematics of microphone systems according to embodiment of the present invention;
Figure 3 illustrates a schematic of an embodiment differential amplifier;
Figures 4A and 4B illustrate cross-sectional views of packaged microphone devices according to embodiments of the present invention; and
Figure 5 illustrates a block diagram of an embodiment method.

Corresponding numerals and symbols in different figures generally refer to corresponding parts unless otherwise indicated. The figures are drawn to clearly illustrate the relevant aspects of the preferred embodiments and are not necessarily drawn to scale. To more clearly illustrate certain embodiments, a letter indicating variations of the same structure, material, or process step may follow a figure number.

### DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

In an embodiment, the asymmetry of a differential MEMS output signal of a differential MEMS device, such as a microphone, is reduced and/or corrected by sensing a common mode component of the AC output signals, amplifying the common mode component, and feeding the amplified common mode component to a bias input node of the differential MEMS device. By feeding back the amplified common mode component to the bias input node of the differential MEMS device, asymmetric behavior of the differential MEMS device and/or amplification circuitry used to amplify the output of the differential MEMS device can be advantageously compensated. In some embodiments, the feedback loop formed by the differential MEMS device, amplification circuitry, and common mode detection circuitry form a dynamic compensation loop that can correct asymmetries in amplitude, phase and/or DC offset between each amplified differential output signal provided by the system. This correction can also advantageously reduce distortion, such as total harmonic distortion (THD) in some embodiments.

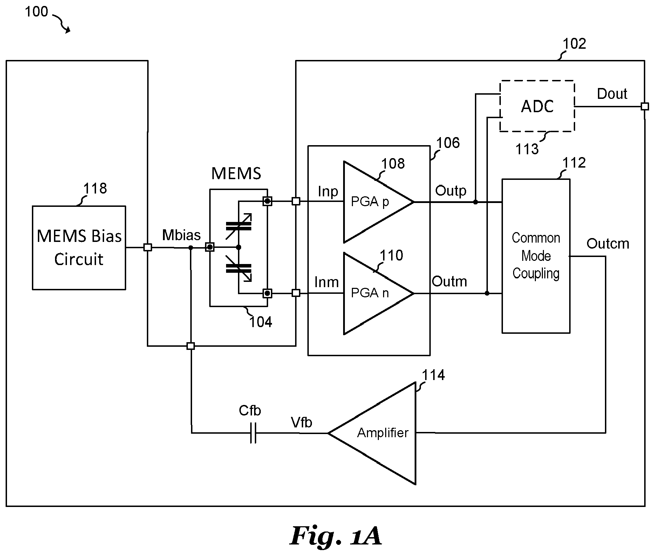

Figure 1A illustrates microphone system 100 that includes integrated circuit 102 coupled to MEMS device 104, which could me be a differential MEMS pressure sensor and/or a differential MEMS microphone. As shown, integrated circuit 102 includes differential amplifier 106, whose output is connected to common mode coupling circuit 112. The output of common mode coupling circuit 112 is coupled to amplifier 114, the output of which is coupled to the bias input node of MEMS device 104 via feedback capacitor Cfb. In some embodiments, capacitor Cfb has a value between about 1 pF and about 10 pF, such as 2 pF; however other suitable values outside of this range may also be used depending on the particular system and its specifications.

MEMS bias circuit 118 (also referred to as a bias generator or bias voltage circuit) provides a bias voltage to MEMS device 104. In analog implementations, the output of differential amplifier 106 may be output directly. Alternatively, optional analog-to-digital converter 113 may be coupled to the output of differential amplifier 106. Hence, the output of analog to digital converter 113 Dout provides a digital signal representative of the sound wave sensed by MEMS device 104. Analog-to-digital converter 113 may be implemented, for example, using analog-to-digital converter architectures known in the art, including but not limited to delta-sigma and successive approximation analog-to-digital converters.

In various embodiments, differential amplifier 106 may be implemented using a pseudo-differential configuration that includes two single ended amplifiers 108 and 110. In some embodiments, amplifiers 108 and 110 may be programmable gain amplifiers having adjustable gains.

MEMS device 104 is shown modeled as two variable capacitors sharing a common mode coupled to node Mbias at a bias input node. In various embodiments, MEMS device 104 may be implemented using a variety of differential MEMS structures known in the art, for example, a double-backplate (DBP) MEMS device or a sealed duel membrane (SDM) MEMS device. In actuality, each variable capacitance represents the capacitance between one or more MEMS membranes and one or more backplates. Thus, as the distance between the MEMS membrane and a respective backplate changes, there is a corresponding change in capacitance. The differential outputs of MEMS device 104 are respectively coupled to the input of amplifiers 108 and 110 at nodes Inp and Inm. During operation, the signals at nodes Inp and Inm may asymmetric with respect to average dc output and amplitude. This asymmetry may cause increased distortion, especially at high signal levels and may limit the maximum usable input range of the microphone.

The sensitivity of MEMS device 104 is established by providing a dc bias voltage at bias input node Mbias. Depending on the particular implementation of MEMS device 104, the bias input node Mbias is coupled to either the membrane or to the backplate of the MEMS device. Generally, the sensitivity of the MEMS device increases with increasing bias voltage. In various embodiments, MEMS bias circuit 118 provides a bias voltage with a very high impedance. For example, MEMS bias circuit 118 may be implemented using a charge pump coupled to bias input node Mbias using a very large ohmic resistor (not shown). This large ohmic resistor may have a resistance, for example, of greater than 1 GΩ and may be implemented, for example, using series-connected diodes or diode connected MOS transistors.

In various embodiments, common mode coupling circuit 112 senses the common mode ac voltage at outputs Outp and Outm of differential amplifier 106, which respectively may be referred to as a first differential output node and a second differential output node. In some embodiments, common mode coupling circuit may be implemented using a voltage divider that includes series-coupled impedances such as resistors or capacitors, as explained hereinbelow in further detail. The output Outcm of common mode coupling circuit 112 is coupled to the input of amplifier 114, which functions as an error amplifier that provides feedback voltage Vfb. This amplified feedback voltage Vfb is coupled to the bias input node Mbias of MEMS device 104, thereby forming a dynamic compensation feedback loop.

In various embodiments, the components of integrated circuit 102 may be disposed on a single monolithic semiconductor integrated circuit, such as a single semiconductor substrate, and/or on the same monolithic semiconductor integrated circuit as other disclosed system components. The semiconductor substrate may be a silicon substrate. Integrated circuit 102 may be fabricated using one of a variety of different semiconductor processes, such as a CMOS process, BiCMOS process, Bipolar process, or other type of process.

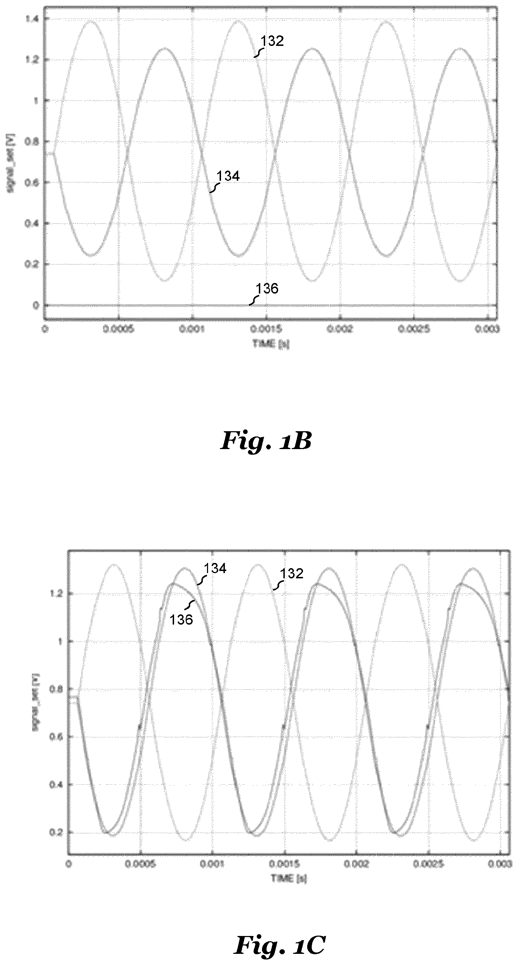

Figures 1B and 1C illustrate waveform diagrams that compare the operation of the microphone system 100 with the dynamic compensation loop disabled (Figure 1B) to the operation of the microphone system 100 with the dynamic compensation loop enabled (Figure 1B). In Figures 1B and 1C, traces 132 and 134 represent the output signals of differential amplifier 106 when MEMS device 104 is provided an acoustic input signal of 125 dBSPL. More specifically, trace 132 represents the voltage at node Outp, trace 134 represents the voltage at node Outm as shown in Figure 1A, and trace 136 represents the voltage of feedback node Vfb at the output of amplifier 114 shown in Figure 1A.

As shown in Figure 1B, which represents the case in which the dynamic compensation loop is disabled, voltages outputs Outp (132) and Outm (134) are asymmetric; the peak-to-peak amplitude of the voltage at output Outp (132) is greater than the peak-to-peak amplitude of the voltage at output Outm (134). The voltage at feedback node Vfb (136) is shown as being grounded at zero volts. The asymmetry of the voltages of Outp (132) and Outm (134) could be due to a number of factors including, but not limited to mismatch between amplifiers 108 and 110, mismatch between the gain settings of amplifiers 108 and 110, mismatches within MEMS device 104, and mismatches in the parasitic environment of microphone system 100.

As shown in Figure 1C, which represents the case in which the dynamic compensation loop is enabled while the other conditions of the microphone system 100 are maintained (including asymmetries in MEMS device 104 and amplifiers 108 and 110). As shown, the voltages at outputs Outp (132) and Outm (134) are symmetric with respect to their respective peak-to-peak amplitudes and dc offset voltages, and the voltage at feedback node Vfb (136) is active. Here the symmetry between voltages at outputs Outp (132) and Outm (134) is due to the action of the dynamic compensation feedback loop forcing a reduction in the ac amplitude of the sensed common mode voltage Outcm of differential amplifier 106.

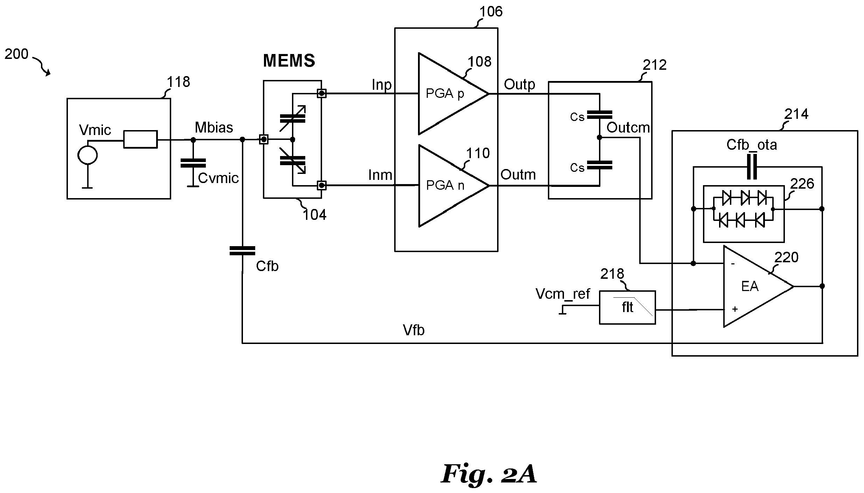

Figures 2A-2C illustrate specific implementations of microphone system 100 depicted in Figure 1A.

Figure 2A illustrates an embodiment microphone system 200 showing further detail of how various blocks of microphone system 100 in Figure 1A could be implemented. For example, common mode coupling circuit 212, which could be used to implement common mode coupling circuit 112 shown in Figure 1A, includes a capacitive voltage divider composed of capacitors Cs. As shown, the common node between capacitors C s is coupled to common mode output node Outcm. Capacitors Cs may each have a value between 1 pF and about 10 pF, such as 2 pF; however other suitable values outside of this range may also be used depending on the particular system and its specifications. In embodiments that include an ADC, such as ADC 113 shown in Figure 1A, capacitors Cs may be incorporated within the first stage or input stage of the ADC.

Amplifier 214 may be used to implement error amplifier 114 shown in Figure 1A. As shown, amplifier 214 includes amplifier 220 with feedback capacitor cfb_ota (also referred to as a capacitive feedback network) coupled in parallel with diode circuit 226, which forms a high resistance bias circuit between output of amplifier 220 and the negative input of amplifier 220. Diode circuit 226 includes two strings of series connected diodes coupled in parallel with opposite orientations. In some embodiments, capacitor cfb_ota has a value between 1 pF and about 10 pF, such as 2 pF; however other suitable values outside of this range may also be used depending on the particular system and its specifications.

In various embodiments, the resistance of diode circuit 226 is at least 1 GΩ. but may be on the order of tens or hundreds of GΩ in some cases. Each of the diodes in diode circuit 226 may be implemented using pn junction diodes or diode connected MOS devices.

Amplifier 220 may be implemented using various amplifier circuits known in the art. For example, amplifier 220 may be implemented using a transconductance amplifier. In the depicted embodiment, the gain of amplifier 214 is approximately two times 2Cs/cfb_ota. In some embodiments, the positive input node of amplifier 220 may be coupled to a common mode reference voltage Vcm_ref. An optional filter 218 may be used to filter voltage Vcm_ref in order to provide a stable reference voltage in various embodiments. Filter 218 may be implemented, for example, using an RC lowpass filter circuit or an active filter.

MEMS bias circuit 118 is shown represented as a voltage source that produces a voltage Vmic coupled in series with a high impedance resistance. In some embodiments, voltage Vmic is generated using a charge pump circuit that may be implemented using charge pump circuits known in the art. The high impedance resistance may be implemented, for example, using a string of series connected diodes or a diode circuit similar to diode circuit 226 or a high ohmic resistor. In Figure 2A, the parasitic capacitance at node Mbias is represented by capacitor Cvmic. This parasitic capacitance may be due to parasitic capacitance on the circuit board, parasitic capacitance at the output of MEMS bias circuit 118, or parasitic capacitance seen at the bias input of MEMS device 104.

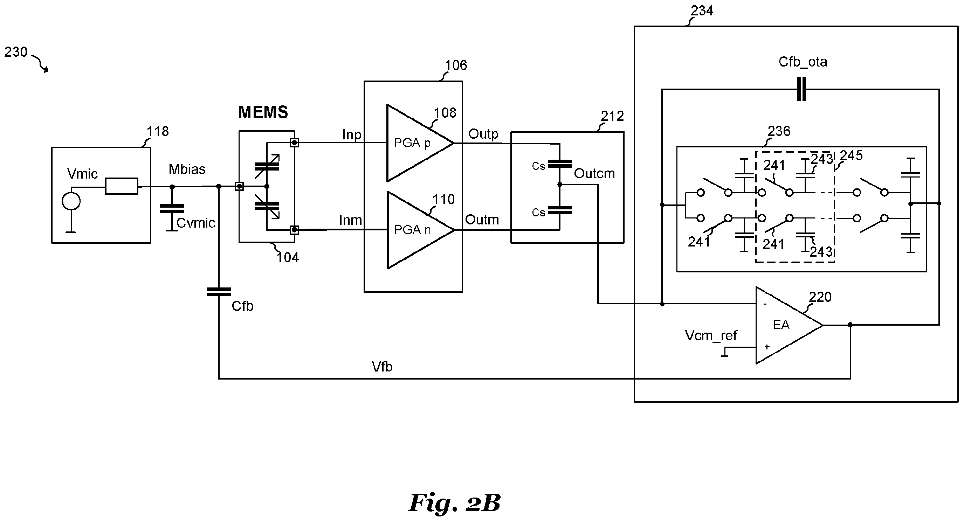

Figure 2B illustrates microphone system 230 according to an alternative embodiment of the present invention. Microphone system 230 is similar to microphone system 200 shown in Figure 2A, with the exception that diode circuit 226 used to implement the high impedance is replaced by switched capacitor resistor circuit 236, which is a switched capacitor circuit that forms a high resistance. As shown, switched capacitor resistor 236 includes a number of cascaded switched capacitor stages 245 that transfer charge packets via switches 241 and capacitors 243. In various embodiments, the value of the resistor is set according to the value of capacitors 243, the number of stages and the switching frequency of switches 241. It should be understood that switched capacitor resistor circuit 236 is just one example of many possible switch capacitor resistor circuits that could be used to implement embodiment high ohmic resistor according to embodiments. While optional lowpass filter 218 is not shown in Figure 2B for simplicity of illustration, it should be understood that lowpass filter 218 may be included in microphone system 230 in some embodiments.

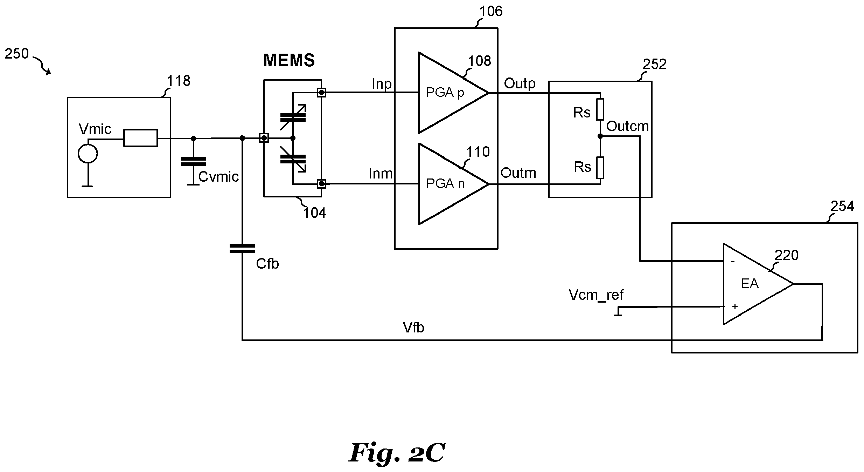

Figure 2C illustrates microphone system 250 according to an alternative embodiment of the present invention in which common mode coupling circuit 252 is implemented using a resistive voltage divider composed of resistors Rs. In alternative embodiments, resistors Rs may be replaced other types of impedance elements, such as a parallel and/or series combination of passive and/or active devices. Other types of circuits that emulate impedances, such as switched-capacitor circuits, could also be used. As shown, error amplification is implemented using a single amplifier 220 without feedback. Amplifier 220 may be an operational amplifier, a transconductance amplifier, or other type of amplifier known in the art.

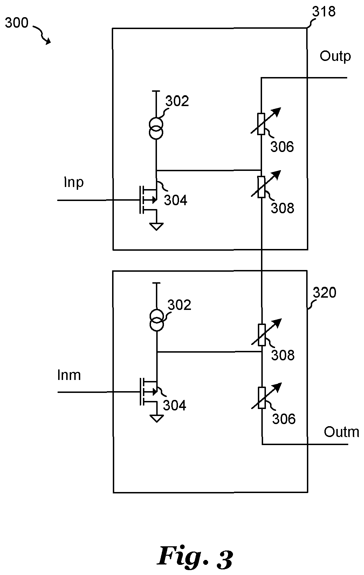

Figure 3 illustrates a schematic of a programmable gain differential amplifier 300 that could be used to implement differential amplifier 106 shown in Figures 1, 2A, 2B and 2C. As shown, programmable gain differential amplifier 300 includes amplifiers 318 and 320, each of which includes a PMOS source follower transistor 304, a current source 302, a first adjustable resistor 306 and a second adjustable resistor 308. Amplifier 318 (corresponding to amplifier 108 in Figures 1A, 2A, 2B and 2C) is configured to amplify positive input Inp to produce positive output Outp, and amplifier 320 (corresponding to amplifier 110 in Figures 1A, 2A, 2B and 2C) is configured to amplify negative input Inm to produce negative output Outm. Together, amplifiers 318 and 320 form a pseudo-differential amplifier. During operation, current source 302 provides bias current to PMOS source follower transistor 304, and the source of PMOS source follower transistor 304 drives the respective common node between resistors 306 and 308. The voltage gain of each stage and hence the entire amplifier (e.g., (V(Outp-V(Outm))/ (V(Inp-V(Inm)) may be adjusted by adjusting the values of resistors 306 and 308. In some embodiments, one or both of resistors 306 and 308 may be implemented using a plurality of series and/or parallel resistor segments and switches (not shown) such that the value of resistor 306 or 308 is programmable by switching in and out resistor segments.

It should be understood that amplifier 300 is just one of many possible differential amplifier circuits that could be used to implement differential amplifiers according to embodiments of the present invention. In alternative embodiments other amplifier circuits such as fully differential amplifiers, amplifiers utilizing super source follower circuits, and other amplifier types known in the art could be used.

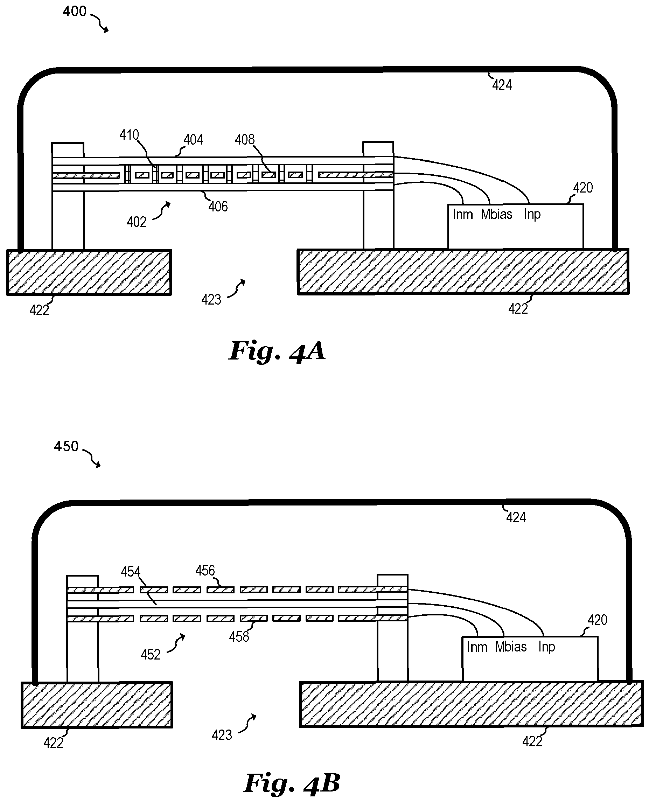

Figures 4A and 4B illustrates cross-sectional views of packaged MEMS microphones according to embodiments of the present invention. Packaged MEMS microphone 400 shown in Figure 4A includes an SDM MEMS device 402 and an integrated circuit 420 disposed on a substrate 422 and enclosed by a lid 424. In some embodiments, SDM MEMS device 402 corresponds to MEMS device 104 and integrated circuit 420 corresponds to integrated circuit 102 that contains the circuitry that interfaces with and amplifies the signals produced by MEMS device 104 described above. As shown, SDM MEMS device 402 includes a first movable membrane 404, a second movable membrane 406 coupled to the first movable membrane 404 via support structures 410, and a counter electrode structure 408.. The cavity between first movable membrane 404 and second movable membrane 406 may be hermetically sealed. The first movable membrane 404, the second movable membrane 406, and the counter electrode structure 408 may include a semiconductive layer, a layer sequence and/or layer stack having a plurality of different layers, where at least one of the layers is electrically conductive.

During operation, MEMS bias circuit 118 (Figure 1A) resident on integrated circuit 420 provides an electrical bias voltage to counter electrode structure 408. Sound pressure received by MEMS device 104 via port 423 deflects membranes 404 and 406 which causes a change in capacitance between the counter electrode structure 408 and each membrane 404 and 406. The resulting electrical signals are coupled to differential amplifier 106 (Figure 1A) resident on integrated circuit 420 via inputs Inp and Inm that are respectively coupled to membranes 404 and 406. These signals are amplified and the common mode ac signal is extracted and amplified and fed back to MEMS device 402 at counter electrode 408 via node Mbias in order to make the output of MEMS device 402 more symmetric.

Substrate 422 may be a printed circuit board (PCB), a redistribution layer or other type of substrate. While MEMS device 402 is shown connected to integrated circuit 420 via wires, such as bond wires, in alternative embodiments, the conductive connection between MEMS device 402 and integrated circuit 420 may be achieved via conductive traces (not shown) on or within substrate 422.

Figure 4B illustrates a packaged MEMS microphone 450 in accordance with an alternative embodiment. Packaged MEMS microphone 450 is similar to packaged MEMS microphone 400 shown in Figure 4A with the exception that a DBP MEMS device 452 is used instead of SDM MEMS device 402. As shown, DBP MEMS device 452 includes a movable membrane 454 suspended between fixed backplates 456 and 458. Each of the movable membrane 454 and fixed backplates 456 and 458 may include a semiconductive layer, a layer sequence and/or layer stack having a plurality of different layers, where at least one of the layers is electrically conductive.

During operation, MEMS bias circuit 118 (Figure 1A) resident on integrated circuit 420 provides an electrical bias voltage to membrane 454. Sound pressure received by DBP MEMS device 104 via port 423 deflects membrane 454 which causes a change in capacitance between membrane 454 and fixed backplates 456 and 458. The resulting electrical signals are coupled to differential amplifier 106 (Figure 1A) resident on integrated circuit 420 via inputs Inp and Inm that are respectively coupled to fixed backplates 456 and 458. These signals are amplified and the common mode ac signal is extracted and amplified and fed back to MEMS device 402 at membrane 454 via node Mbias in order to make the output of MEMS device 402 more symmetric.

It should be understood that the packaged MEMS microphones shown in Figures 4A and 4B are just two of many possible examples of MEMS systems that may utilize embodiment amplification and common mode feedback systems and methods as described above. Moreover, other differential MEMS structures could be used beside the SDM and DBP MEMS devices depicted in Figures 4A and 4B.

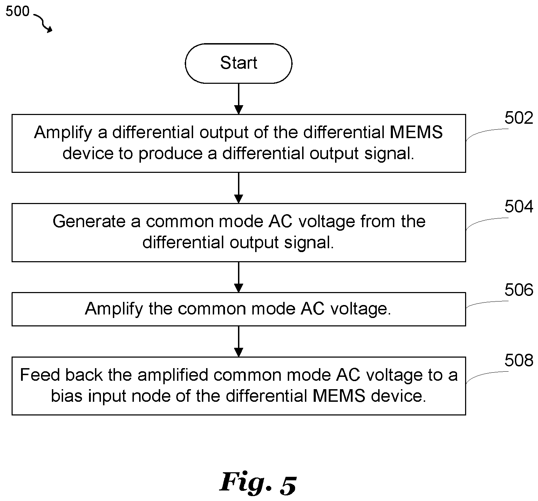

Figure 5 illustrates a flow chart of a method 500 of operating a differential MEMS system according to an embodiment of the present invention. In step 502, the differential output of a differential MEMS device is amplified to produce a differential output signal. This step may be implemented, for example, using differential amplifier 106 and/or differential amplifier 106 implemented according to the embodiment of Figure 3 as described above.

In step 504, a common mode ac voltage is generated from the differential output signal. This step may be implemented, for example, using common mode coupling circuits 112, 212, and 252 described above with respect to Figures 1A, 2A, 2B and 2C. For example, a voltage divider using impedance elements such as resistors or capacitors may be used to determine the common mode ac voltage.

In step 506, the common mode ac voltage is amplified. This amplification may be achieved using an amplifier circuit, such as amplifier 114, 214, 234 and 254 described above with respect to Figures 1A, 2A, 2B and 2C.

Next, in step 508, the amplified common mode ac voltage is fed back to a bias input node of the differential MEMS device. In some embodiments, this voltage is fed back to the bias input node via a capacitor such as capacitor Cfb. Feeding back the amplified advantageously causes the differential output signal of the differential MEMS device or the differential output to be more symmetric.

Embodiments of the present invention are summarized here. Other embodiments can also be understood from the entirety of the specification and the claims filed herein.

Example 1. A circuit including: a differential amplifier having inputs configured to be coupled to an output of a differential microelectromechanical systems (MEMS) device; a common mode coupling circuit coupled to an output of the differential amplifier; and an amplifier having an input coupled to an output of the common mode coupling circuit and an output configured to be AC coupled to a bias input node of the differential MEMS device.

Example 2. The circuit of example 1, further including a capacitor having a first terminal coupled to the output of the amplifier and a second terminal configured to be coupled to the bias input node of the MEMS device.

Example 3. The circuit of one of examples 1 or 2, where the common mode coupling circuit includes a first resistor coupled between a first differential output node of the differential amplifier and the input of the amplifier, and a second resistor coupled between a second differential output node of the differential amplifier and the input of the amplifier.

Example 4. The circuit of one of examples 1 to 3, where the common mode coupling circuit includes a first capacitor coupled between a first differential output node of the differential amplifier and the input of the amplifier, and a second capacitor coupled between a second differential output node of the differential amplifier and the input of the amplifier.

Example 5. The circuit of example 4, further including a feedback capacitor coupled between the input of the amplifier and the output of the amplifier.

Example 6. The circuit of example 5, further including a high resistance bias circuit coupled in parallel with the feedback capacitor.

Example 7. The circuit of example 6, where the high resistance bias circuit includes a switched capacitor circuit.

Example 8. The circuit of example 6, where the high resistance bias circuit includes a plurality of diodes coupled in series.

Example 9. The circuit of one of examples 1 to 8, further including a bias voltage circuit configured to be DC coupled the bias input node of the MEMS device.

Example 10. The circuit of one of examples 1 to 9, further including the MEMS device.

Example 11. The circuit of one of examples 1 to 10, where the differential amplifier, the common mode coupling circuit, and the amplifier are disposed on a single semiconductor substrate.

Example 12. A method of operating a differential microelectromechanical systems (MEMS) device, the method including: amplifying a differential output of the differential MEMS device to produce a differential output signal; and reducing an asymmetry of the differential output signal including: generating a common mode AC voltage from the differential output signal, amplifying the common mode AC voltage, and feeding back the amplified common mode AC voltage to a bias input node of the differential MEMS device.

Example 13. The method of example 12, further including: generating a DC bias voltage; and DC coupling the DC bias voltage to the bias input node of the differential MEMS device.

Example 14. The method of one of examples 12 or 13, where generating the common mode AC voltage includes using a capacitive voltage divider coupled to outputs of the differential MEMS device.

Example 15. The method of one of examples 12 to 14, where amplifying the common mode AC voltage includes using an amplifier with a capacitive feedback network.

Example 16. The method of one of examples 12 to 15, where generating the common mode AC voltage includes using a resistive voltage divider coupled to outputs of the differential MEMS device.

Example 17. The method of one of examples 12 to 16, where feeding back the amplified common mode AC voltage includes feeding back the amplified common mode AC voltage to the bias input node of the differential MEMS device via a capacitor.

Example 18. The method of one of examples 12 to 17, where: the differential MEMS device includes a differential MEMS microphone; and the method further includes amplifying sound using the differential MEMS microphone.

Example 19. A microphone system including: a differential microelectromechanical systems (MEMS) device; a differential amplifier coupled to an output of the differential MEMS device; an amplifier; a first impedance coupled between a first differential output of the differential amplifier and a first input node of the amplifier; a second impedance coupled between the first differential output of the differential amplifier and the first input node of the amplifier; a third capacitor coupled between an output of the amplifier and a bias input node of the differential MEMS device; and a bias generator DC coupled to the bias input node of the differential MEMS device.

Example 20. The microphone system of example 19, where the differential amplifier, the amplifier, the first capacitor, the second capacitor and the bias generator are disposed on a single semiconductor substrate.

Example 21. The microphone system of one of examples 19 or 20, where the differential amplifier has a programmable gain.

Example 22. The microphone system of one of examples 19 to 21, where: the first impedance includes a first capacitor; and the second impedance includes a second capacitor.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A circuit comprising:
a differential amplifier having inputs configured to be coupled to an output of a differential microelectromechanical systems (MEMS) device;
a common mode coupling circuit coupled to an output of the differential amplifier; and
an amplifier having an input coupled to an output of the common mode coupling circuit and an output configured to be AC coupled to a bias input node of the differential MEMS device.

2. The circuit of claim 1, further comprising a capacitor having a first terminal coupled to the output of the amplifier and a second terminal configured to be coupled to the bias input node of the MEMS device.

3. The circuit of claim 1 or 2, wherein the common mode coupling circuit comprises a first resistor coupled between a first differential output node of the differential amplifier and the input of the amplifier, and a second resistor coupled between a second differential output node of the differential amplifier and the input of the amplifier.

4. The circuit of any of claims 1 to 3, wherein the common mode coupling circuit comprises a first capacitor coupled between a first differential output node of the differential amplifier and the input of the amplifier, and a second capacitor coupled between a second differential output node of the differential amplifier and the input of the amplifier,
wherein, for example, the circuit may further comprise a feedback capacitor coupled between the input of the amplifier and the output of the amplifier, and
wherein, for example, the circuit may further comprise a high resistance bias circuit coupled in parallel with the feedback capacitor, and wherein, for example, the high resistance bias circuit may comprise a switched capacitor circuit or a plurality of diodes coupled in series.

5. The circuit of any of claims 1 to 4, further comprising
the MEMS device, and/or
a bias voltage circuit configured to be DC coupled to the bias input node of the MEMS device.

6. The circuit of any of claims 1 to 5, wherein the differential amplifier, the common mode coupling circuit, and the amplifier are disposed on a single semiconductor substrate.

7. A method of operating a differential microelectromechanical systems (MEMS) device, the method comprising:
amplifying a differential output of the differential MEMS device to produce a differential output signal; and
reducing an asymmetry of the differential output signal comprising:
generating a common mode AC voltage from the differential output signal,
amplifying the common mode AC voltage, and
feeding back the amplified common mode AC voltage to a bias input node of the differential MEMS device.

8. The method of claim 7, further comprising:
generating a DC bias voltage; and
DC coupling the DC bias voltage to the bias input node of the differential MEMS device.

9. The method of claim 7 or8, wherein generating the common mode AC voltage comprises using a capacitive voltage divider coupled to outputs of the differential MEMS device, and
wherein, for example, amplifying the common mode AC voltage may comprise using an amplifier with a capacitive feedback network.

10. The method of any of claims 7 to 9, wherein generating the common mode AC voltage comprises using a resistive voltage divider coupled to outputs of the differential MEMS device.

11. The method of any of claims 7 to 10, wherein feeding back the amplified common mode AC voltage comprises feeding back the amplified common mode AC voltage to the bias input node of the differential MEMS device via a capacitor.

12. The method of any of claims 7 to 11, wherein:
the differential MEMS device comprises a differential MEMS microphone; and
the method further comprises amplifying sound using the differential MEMS microphone.

13. A microphone system comprising:
a differential microelectromechanical systems (MEMS) device;
a differential amplifier coupled to an output of the differential MEMS device;
an amplifier;
a first impedance coupled between a first differential output of the differential amplifier and a first input node of the amplifier;
a second impedance coupled between the first differential output of the differential amplifier and the first input node of the amplifier;
a third capacitor coupled between an output of the amplifier and a bias input node of the differential MEMS device; and
a bias generator DC coupled to the bias input node of the differential MEMS device.

14. The microphone system of claim 13, wherein the differential amplifier, the amplifier, the first capacitor, the second capacitor and the bias generator are disposed on a single semiconductor substrate.

15. The microphone system of claim 13 or 14, wherein the differential amplifier has a programmable gain.

16. The microphone system of any of claim 13 to 15, wherein:
the first impedance comprises a first capacitor; and
the second impedance comprises a second capacitor.
